Europäisches Patentamt

European Patent Office

Office européen des brevets

(11) Publication number: **0 217 019 B1**

(12) **EUROPEAN PATENT SPECIFICATION**

(45) Date of publication of patent specification: **12.06.91**  (51) Int. Cl.⁵: **H05K 7/06, H05K 13/06, H05K 3/10**

(21) Application number: **86109605.5**

(22) Date of filing: **14.07.86**

(54) Method of manufacturing interconnection circuit boards.

(30) Priority: **19.07.85 US 756691**

(43) Date of publication of application:
**08.04.87 Bulletin  87/15**

(45) Publication of the grant of the patent:
**12.06.91 Bulletin  91/24**

(84) Designated Contracting States:
**AT CH DE FR GB IT LI SE**

(56) References cited:
**EP-A- 0 113 820**
**FR-A- 2 304 247**
**GB-A- 2 146 177**

(73) Proprietor: **Advanced Interconnection Technology, Inc.**
**181 Freeman Avenue**
**Islip, NY 11751(US)**

(72) Inventor: **Morino, Ronald**
**11 Raymond Court**
**Sea Cliff, NY 11579(US)**
Inventor: **Swiggett, Brian Edward**
**25 Larue Drive**
**Huntington, NY 11743(US)**
Inventor: **Keogh, Raymond J.**
**19 Whitehall Drive**
**Huntington, NY 11746(US)**
Inventor: **Crowell, Jonathan Clark**
**12 Lincoln Street**
**Lakeville, MA 02347(US)**

(74) Representative: **Königseder-Egerer, Claudia D.**
**Zugspitzstrasse 65**
**W-8104 Grainau(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to the manufacture of wire-scribed interconnection circuit boards, and more particularly to the use of laser energy for bonding and stripping conductors during the scribing process.

In US-A 3671914 and US-A 3674602 is described a process and apparatus for scribing conductors onto an insulating substrate which has been precoated with an adhesive layer by contiunuously feeding a fine insulated wire onto the surface of the substrate, affixing the conductors to the substrate, and cutting them at predetermined points. The process described is capable of producing a conductor network of a predetermined interconnection pattern.

The conductor pattern is formed by tacking the insulated wire to the adhesive layer by means of a scribing element which locally heats the adhesive layer. The adhesive melts, is formed to at least partially surround the conductor and then, upon cooling, creates a bond between the conductor and the substrate.

In co-pending European Patent application No. 86109558.6 there is disclosed and described a process for applying conductors, such as conductors capable of transmitting electrical energy or light between conductor points, to the surface of a base or circuit board having spaced terminal points thereon, said process comprising adhesively bonding a conductor having an adhesive coating, such as of a thermosetting adhesive composition, to the surface of the board, by first activating or softening the adhesive composition with, e.g., heat, applying the conductor with the activated adhesive to the base and, as the conductor is applied, setting, hardening or curing the adhesive coating to affix or attach the conductor to the base surface. Such process has been found to be particularly suited for adding conductors to bases or boards having existing circuit patterns. The process is also suited for the manufacture of new circuit boards.

In co-pending European Patent application No. 86109607.1 there is disclosed and described an apparatus for scribing a conductor to a surface of a substrate in a predetermined pattern between two terminal points on said surface. The conductors are coated, at least on the side to be adhered to the surface, with a heat responsive adhesive. The end of the conductor is tacked or affixed to the base at the first of the terminal or contact points to be joined. The adhesive coating on the side of the conductor to be adhesively affixed is then activated. As the adhesive coating is activated and softened, the conductor is pressed against the board surface along the path the conductor is to be applied or scribed. Such heating, pressure applying and scribing of the coated conductor is accomplished while it is being fed from a feeding means aligned with the path in which the conductor is to be applied or scribed and the feeding means and the board are moved relative to each other along said path. At the second contact point, the conductor is cut and the cut end fixed to the second terminal or contact point.

European Patent Publication No. 0113820 discloses a method and apparatus for scribing wires onto an activated layer of photocurable adhesive. The adhesive is activated using either ultrasonic energy, optical energy or some combination of the two and subsequently cured by means of optical energy which may be laser energy.

Japanese Laid-open Patent No. 57-236391 describes a process wherein wires are scribed in a predetermined pattern onto an adhesive-coated surface of a substrate. Laser energy in combination with ultrasonic energy is used to soften the adhesive and press the wire into the adhesive as the wire is being scribed.

There are, however, many problems and obstacles faced in using a laser beam as an energy source to activate an adhesive used in the scribing process, whether the adhesive is located on the surfce to be scribed or on the conductor. Directing laser energy to the adhesive as a continuous beam achieves a consistent level of activation along the predetermined conductor pattern only if the laser beam is moved along the adhesive at a constant velocity, or its intensity modulated according to complex control variables. The energy received by a particular section of the adhesive increases as the duration of its exposure to the energy increases. The duration of exposure is inversely proportional to the velocity at which the laser beam moves along the predetermined pattern on the adhesive. Thus, if the speed at which a conductor is scribed, also referred to as scribing speed, changes, the exposure time of the adhesive in different areas also varies. During the scribing process, the scribing element can change the scribing speed under at least three circumstances: when the scribing element accelerates from a stop to a predetermined running speed; when an inflection or turn is made (requiring the scribing element to decelerate before making a turn, to stop in order to make the inflection, and to accelerate to the running speed after making the turn); and when the scribing element decelerates to a stop at the end of a conductor run. As a result, when the speed of the scribing element is lower than the running speed, the adhesive receives excess energy causing it or surrounding materials to be scorched or damaged. If the level of laser energy is lowered to compensate for the excess energy at lower speeds, the amount of energy received by other sections of adhesive at running speed may be insufficient to activate the adhesive. It is, therefore, an object of the invention to provide a method for scribing conductors in a predetermined pattern onto a substrate using a precisely controlled laser beam or beams to activate the adhesive used to bond the conductors to the substrate.

It is a further object to provide a method for effective adhesive bonding and wire stripping of scribed conductors using one or more laser beams.

By 'substrate' is meant the insulating material on which a conductor pattern is formed.

By 'conductor' is meant at least one preformed, elongated filament having at least one portion, referred to as conductive portion, capable of conducting energy, such as electrical energy or light energy. Conductors may be coated with an insulation layer.

By 'scribing' is meant the process of applying and affixing conductors to a substrate in a predetermined pattern.

By 'laser energy' is meant the amount of energy emitted from a laser energy source and is the product of power and time.

By 'adhesive' is meant the material used to bond a conductor to a surface of a substrate. The adhesive may be a coating encapsulating a conductor, may be placed on the surface of the substrate or may be supplied separately as a film.

By 'activate' is meant the process of rendering the adhesive tacky and capable of forming a bond.

The process of the invention as claimed for scribing a conductor in a predetermined pattern on a surface of a substrate comprises providing at least one conductor, a substrate the surface of which is to be scribed, and an adhesive for bonding said conductor to said surface; scribing the conductor on said surface of the substrate following a predetermined path, activating said adhesive along said predetermined path and is characterized in that the activating step is carried out by directing substantially uniform laser beam pulses at said adhesive; and timing said pulses such that the pulse repetition rate is a function of the scribing speed.

It has been found by applicant that a laser beam may be used to activate adhesives in a process for scribing conductors in an easily-controlled manner by a series of discrete laser beam pulses directed toward the adhesive. The pulses are preset to contain uniform quanta of energy according to conditions such as laser beam cross section (hereinafter referred to as focus), source efficiency, adhesive activation requirements and the like. A pulse is emitted each time a predetermined incremental portion of the conductor is scribed along the conductor path. In this way, each unit length, and thus unit area, along the conductor path receives substantially the same amount of energy regardless of the scribing speed. The method of this invention thus provides an accurate, consistent, and simple means for activating adhesive and scribing conductors to form an interconnection pattern. The laser energy can also be used to achieve insulation stripping, soldering and cutting of conductors at the terminal points.

Figure 1 is a cross-sectional view of a scribing head for laser bonding insulated wire to an adhesive coated substrate.

Figure 2 is a cross-sectional view of a scribing head according to another embodiment of the invention wherein the adhesive is supplied separately.

Figures 3A, 3B and 3C are cross-sectional views at different magnifications illustrating a dual laser beam embodiment where an adhesive is supplied coated on the wire.

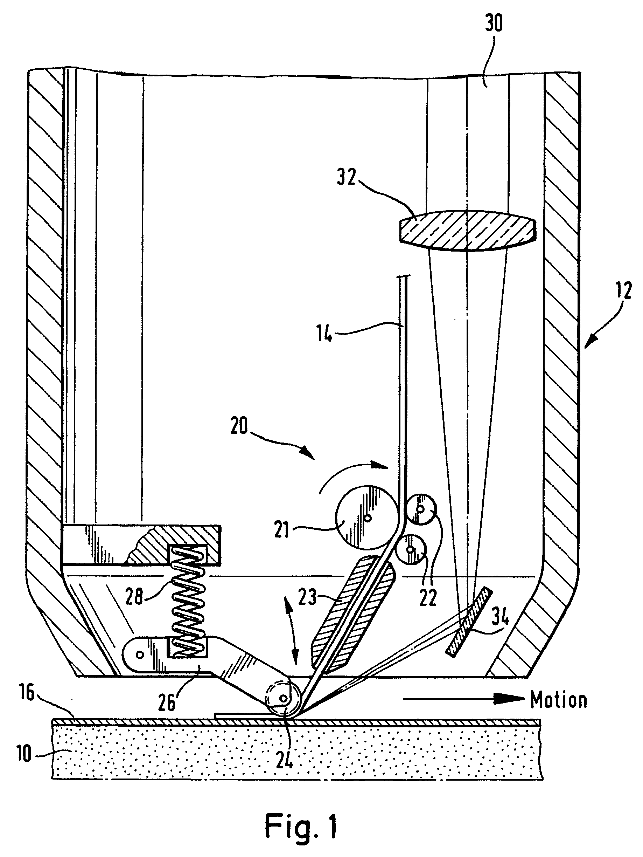

Fig. 1 shows a scribing head suitable for a laser bonding of scribed conductors where the adhesive is applied to the surface of the substrate. The substrate 10 is preferably mounted on an X-Y table for controlled movement. Preferably, the table positioning is digitally controlled in accordance with a computer program. A scribing head 12 dispenses insulated wire 14 and is rotatable so that the wire is dispensed in the direction of the table movement. In a typical sequence, the table moves in one direction while scribing a wire of a predetermined conductor length, then the table stops to permit head rotation to provide a turn or inflection in the conductor run, then the table moves in a new direction indicated by the head position. In this fashion, a conductor path is provided on the substrate surface.

The substrate 10 is coated with an adhesive layer 16 for bonding the insulated wire to the substrate.

Insulated wire 14 is supplied via a wire feed 20 including a drive roller 21 and a pair of idler rollers 22. The drive roller 21 is preferably controlled so that the wire 14 is fed at a rate coinciding with the rate at which the substrate 10 is moved by the table (not shown). The wire 14 passes from the wire feed 20 through a wire guide 23 to the adhesive coated surface 16 of the substrate and is pushed downwardly by a grooved guide roller 24 mounted at the free end of a pivotable arm 26 urged downwardly by means of a spring 28.

A laser beam 30 is focussed by a lens 32 and reflected off a mirror 34 to the adhesive surface at, or slightly ahead of, the contact point between the insulated wire and the adhesive surface. The laser beam is in the form of fixed energy pulses supplied in accordance with the incremental displacements of the table so as to activate the adhesive beneath the wire as the wire is being scribed. The roller pushes the wire into the soft activated adhesive. Thereafter, the adhesive rapidly solidifies forming a secure bond between the wire and the substrate.

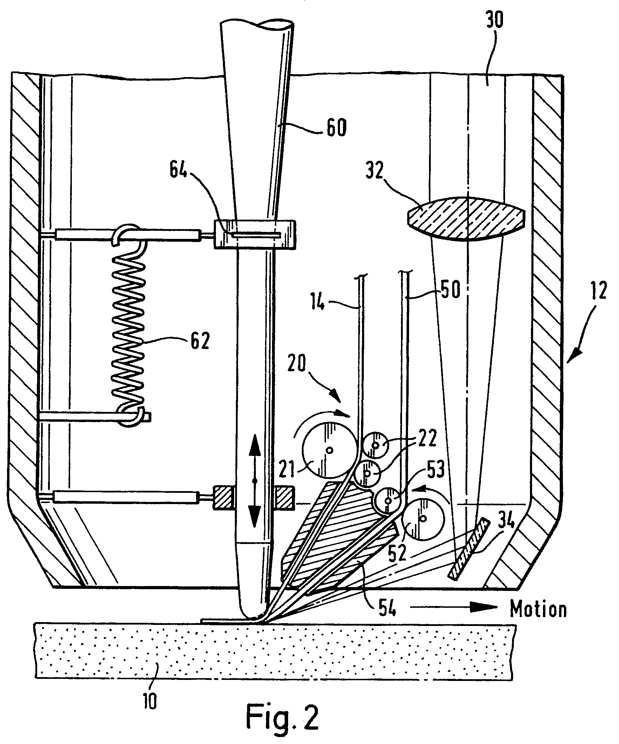

Fig. 2 illustrates another embodiment wherein the adhesive is supplied separately and wherein the wire is pressed into the adhesive by an ultrasonic stylus. The adhesive film 50 passes between a drive roller 52 and idler roller 53 so that the film advances simultaneously with the wire 14. The adhesive film 50 is slightly wider than the wire. Film 50, as it emerges from feed rollers 52 and 53, passes through a guide 54 and is laid down on the substrate 10 beneath the insulated wire 14. Laser beam 30 is directed by mirror 34 to activate the adhesive just prior to the contact with the substrate surface. Stylus 60 is energized by ultrasonic vibration and is grooved at the end to provide a wire guide to position the wire on the substrate surface. The stylus is shaped to provide a relatively small frictionless wire guide and presses the wire into the adhesive activated by the laser pulses. The ultrasonic energy is maintained at a low amplitude level sufficient to provide the frictionless guide. The stylus thus does not contribute significantly to the energy supplied for activating the adhesive. At the low energy levels used in accordance with the invention, the ultrasonic energy is found usable without creating significant cold working or breaking of the insulated wire.

The downward force of the stylus is supplied by spring 62 which is attached to the stationary node point 64 of the stylus 60.

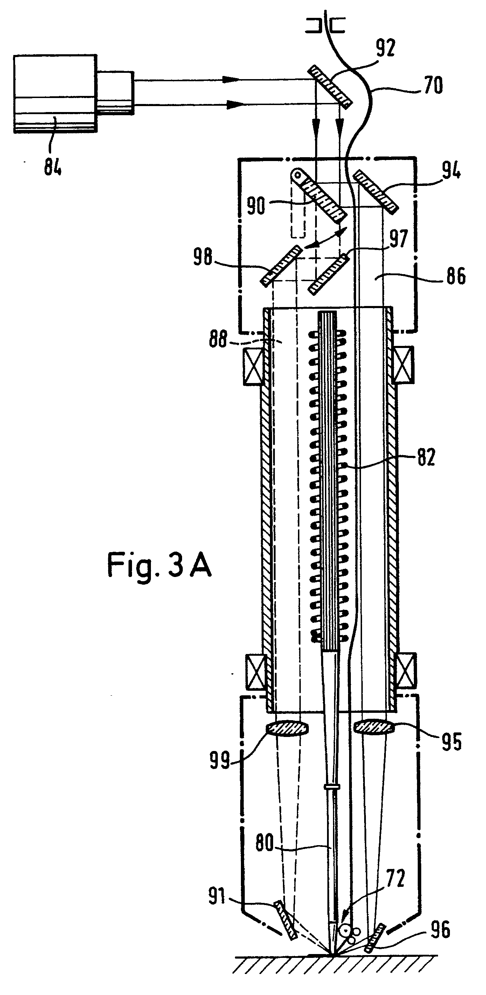

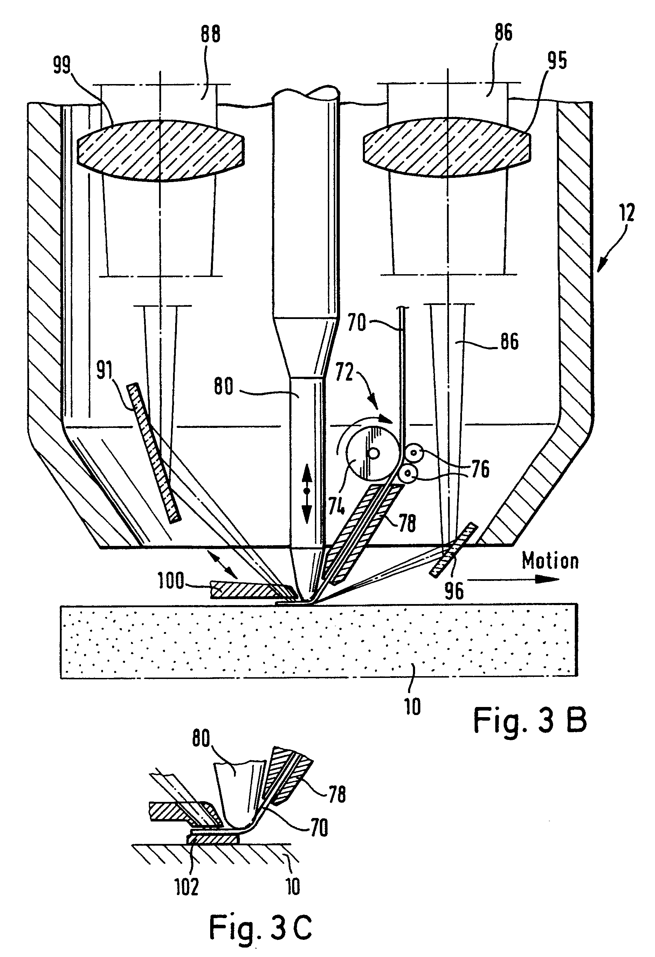

Figures 3A, 3B and 3C illustrate a dual beam embodiment for cutting, stripping and soldering as well as adhesive activation. In this embodiment, the adhesive is precoated onto the insulated wire.

The coated wire is supplied via a wire feed 72 including a drive roller 74 and a pair of idler rollers 76. Thereafter, the wire passes through a wire guide 78 and beneath a grooved ultrasonic stylus 80. The stylus is generally shaped as shown in Fig. 3A and is energized by magnetostriction as a result of high frequency energy supplied to a coil 82 surrounding the stylus 80. When energized, the working end of the stylus vibrates up and down.

A laser 84 provides laser energy in controlled pulses via either of two beams 86 and 88, as determined by a pivotal mirror 90. Mirror 90 being in the solid line position, the laser energy is reflected off mirrors 90, 92, 94, passes through lens 95 and is then reflected off mirror 96 to the underside of the coated wire at the point of contact with substrate 10. When mirror 90 is in the dotted line position, the laser energy is reflected off mirrors 92, 97, 98, passes through lens 99 and is then reflected off mirror 91, to the upper side of the insulated wire being scribed. The laser energy reflected off mirror 91, as can be seen in Figs. 3B and 3C, passes through an aperture in a wire clamp 100 which holds the wire in place during stripping, cutting and soldering operations. In a typical operating sequence, the wire end is pushed into position under clamp 100 by wire feed 72 and the sufficient energy is supplied via pulsed laser beam 88 to vaporize the insulation on the conductor. Sufficient energy can also be supplied to solder or weld the conductor to a terminal pad 102 on the substrate surface.

The X-Y table then moves the substrate in a direction indicated by the scribing head to provide a straight conductor run. Laser energy from beam 86 activates the adhesive prior to contact with the substrate and stylus 80 presses the wire into contact with the substrate surface.

As the adhesive cools a bond is formed between the insulated wire and the substrate. If turns or inflection points are required in the conductor run, the table movements stops, scribing head 12 rotates to a new direction to provide the turn or inflection in the conductor, and the table then moves in a new direction indicated by the scribing head position. At the end of the conductor run laser energy is supplied via beam 88 to again strip insulation off the conductor and to solder or weld the conductor to a terminal pad on the substrate. Thereafter, the table can be moved slightly so that beam 88 is focussed on the conductor just beyond the terminal pad and sufficient energy at the proper wavelength is supplied to cut through the conductor.

For cutting operations, laser energy at a shorter wavelength is preferable to achieve greater energy absorption by the copper. A neodymium doped yttrium-aluminum-Garnet laser with a wavelength of 1.06 microns is a preferred selection for the cutting operation.

The laser beam used to activate the adhesive to scribe a conductor to the surface of a substrate must be carefully configured and controlled within certain spatial and time limits. Careful configuration and control allows the adhesive to receive sufficient energy to become activated for bonding the conductor. If the laser energy is not properly configured and controlled, inadequate bonding between the conductor and surface occurs due to gaps and inconsistencies in the bond formed. Excess energy, on the other hand, can damage the conductor or surrounding materials.

The process of this invention avoids these problems and achieves consistent activation of the adhesive along the entire length of the conductor. In order to achieve this goal, the total amount of energy received by a unit area of the adhesive should be constant, independent of the speed at which the impingement of the laser beam moves along the surface of the adhesive.

As previously mentioned, adhesive may be placed either on the surface of the substrate or coated onto the conductor itself, or supplied separately. The impingement of the laser beam moves on the adhesive with the scribing head along the conductor path. A fixed quantum of energy is emitted in pulse form and received by a predetermined area of the adhesive when a fixed length of the conductor path is traversed by the scribing head and the impinging laser beam. After the adhesive has been activated, the conductor is placed on the substrate surface. As the adhesive loses energy received from the laser beam, it reverts to a non-tacky state, and forms a bond between the conductor and the surface of the substrate to which the conductor has been scribed. The pulsed laser beam is directed toward the adhesive either on the wire or on the surface and its locus of impingement moves along the surface just prior to or simultaneously with the scribing head placing the conductor in contact with the substrate.

The laser beam pulses all have substantially equal amounts of energy. The energy of the pulse is the product of the pulse amplitude, or power level of the pulse, and the pulse width, or duration of the pulse. Each pulse should have at least enough energy to render the area on which it impinges tacky for the time period required to scribe that area of the conductor to the surface of the substrate. The pulse energy should be below the value which causes C-stage curing of the adhesive or damage to surrounding areas. The energy of the pulses is set prior to the start of the scribing process.

A pulse of laser energy is emitted each time an incremental distance is transversed along the adhesive. The number of pulses emitted per unit time, or the "pulse repetition rate", therefore, necessarily varies as the distance traversed per time unit. In other words, it varies as a function of the scribing speed.

Thus, according to the method of this invention, regardless of variations in the scribing speed, the amount of energy received by each unit area of the adhesive remains constant. This results in uniform, consistent bonding along the entire length of the conductor being scribed.

The scribing element momentarily maintains the desired conductor position of the surface, but as the scribing head moves on, its ability to control the conductor position is lost. The adhesive, therefore, should quickly form a bond between the conductor and the substrate surface to maintain the desired position.

Preferably, the adhesive, after activation, should revert to a non-tacky state to form the bond within about 50 to about 200 milliseconds in order to maintain the desired conductor position. One advantage of using a controlled predetermined energy pulse just sufficient to activate the adhesive is that the time the adhesive takes to heat, activate, and lose the heat energy, (the "thermal cycle"), is considerably reduced. By matching the amount of energy emitted to the amount of energy required to activate the adhesive, the duration of the thermal cycle is reduced and the required bond is formed more quickly than if excess energy is applied.

Preferably, the laser pulse energy level is preset to the minimum energy needed to activate the particular adhesive used in scribing a conductor. To determine this setting, the adhesive to be used in the scribing process is baked and the temperature increase required to render the adhesive tacky is measured. Then, a laser beam is pulsed for the shortest duration possible at a particular area of the adhesive and the temperature increase of that area measured. The pulse energy level is adjusted to find the level which reliably raises the temperature to a degree sufficient to render the adhesive tacky.

The distance between pulses impinging along the scribed conductor can also be set prior to scribing. The distance should be sufficiently small to afford continuous bonding along the length of conductor. The extent of continuous bonding can be determined by microscopic examination of the scribed conductor.

The spot size is preferably small. If, however, the spot size is too small, a slight misalignment may cause the laser beam to miss the conductor and the adhesive thereon. Preferably, the spot size diameter is approximately four to five times as large as the conductor diameter. The spot size should be limited to avoid heating the apparatus surrounding the scribing area, potentially causing damage and malfunctions.

The energy distribution in a spot can be varied, but preferred is the one-lobe Gaussian distribution in which the greatest amount of energy is concentrated at the center of the spot and the concentration decreases towards the periphery. In order to maintain a consistent level of activation along the conductor, the laser pulses should be spaced so that the spots overlap. The extent of the overlap depends upon the distribution of the pulse energy. The more diffuse the energy distribution, the greater the overlap should be. Preferably, the spots should overlap to an extent approximately 10 to about 90 percent of the diameter of the spot. More preferably, they should overlap by about 80% of the diameter of the spot.

When scribing conductors to a surface coated with a layer of adhesive, a pulsed $CO_2$ laser is preferably used. The pulse amplitude is preferably from about 5 to about 10 Watts, the pulse width is from 50 to 2000 microseconds. The distance between pulses is preferably from 0.05 to 0.25 mm. The diameter of the spot is preferably between 0.18 and 0.75 mm. The scribing speed ranges from 0 to 38 cm/sec. or higher. Preferred ranges of these parameters may vary depending upon the adhesive used.

The power level of the laser beam may fluctuate during use since the signal output of a sealed laser decays over time as it is used. Further, there may be momentary variations in the signal during a single scribing procedure. The method of this invention provides a convenient means to compensate for brief fluctuations in power output.

The power level of a sealed laser beam should be sampled over time. As the power output decays, the energy reaching the adhesive decreases. In accordance with this invention, the energy reaching the adhesive can be increased simply by increasing pulse width or amplitude or by decreasing the distance between pulses, (increasing the overlap of pulses impinging on the adhesive), which is tantamount to increasing the pulse repetition rate.

If an unsealed laser is used, the average power output can be measured by diverting a small fraction of the beam (approximately 5 to 10%) and measuring its power level. As the power level of the diverted beam changes, the power level of the major portion of the beam is changed accordingly, e.g., the pulse width can be varied to compensate for power fluctuations.

EXAMPLE 1

A conductive pattern for power and ground connections of an interconnection board was etched into the copper surfaces of a copper-clad epoxy-glass laminate substrate, known in the interconnection industry as an "FR-4" board. An insulated conductor having a copper wire conductive portion and having an overall diameter of 1.5 mm was scribed onto the adhesive surface using a stylus as the scribing element. A $CO_2$ laser was used to activate the adhesive during the scribing process. The available power output of the laser source was about 150 Watts. The power output per pulse required for the adhesive used was between about 5 and 10 Watts. The energy distribution mode of the beam was chosen to be the transverse electromagnetic mode $TEM_{oo}$, a one-lobe Gaussian curve mode.

An adhesive layer having the following solids composition was laminated over the epoxy-glass laminate under heat and pressure:

| | |
|---|---|
| Acrylonitrile-butadiene copolymer rubber | 26.9 % |
| Alkyl phenolic resole resin | 13.4 % |
| Digylcidyl ether of Bisphenol A1 molecular weight appr. 1000 | 8.9 % |
| Chlorosulfonate polyethylene rubber | 8.9 % |
| Phenolic novolac resin containing hexamethyl triamine | 13.4 % |
| Zirconium silicate (filler) | 17.9 % |
| Palladium chloride liquid epoxy resin reaction product with 10% Pd | 2.6 % |
| Fumed silica | 4.5 % |
| Flow agent - vinyl silane | 0.9 % |
| Copper phthalocyanine pigment | 2.6 % |

Prior to lamination, the composition included 3-6% Cellosolve acetate, high flash naptha and methyl ethyl ketone as solvents.

The size of the beam output from the laser before the beam was transmitted through an optical system, the "raw beam diameter", was 10 mm. The raw beam was then transmitted through the optical system and focussed onto the adhesive surface at an angle to form an oval-shaped spot spproximately 0.5 mm wide and 0.75 mm long. The pulse width was chosen to be 100 microseconds. The distance between pulses was chosen to be 0.1 mm. The laser beam was directed to a point approximately 0.25 mm in front of the stylus such that during the scribing process the region of activated adhesive was 0.25 mm away from the stylus tip, the point at which conductor is dispensed. At a scribing speed of 125 mm/sec., uniform bonding to the substrate was achieved along the entire length of the conductor.

EXAMPLE 2

An elongated preformed wire conductor, for example, a copper wire of 0.1 mm diameter, plated with approximately 0.5 $\mu$m of silver, is covered with a layer of polyurethane insulation, 38 $\mu$m thick. The conductor is further provided with an adhesive coating having the following dry weight composition:

| | |
|---|---|
| high molecular weight polyurethane acrylate | 100 g |
| epoxy acrylate | 15 g |
| polyisocyanurate of toluene di-isocyanate | 9.8 g |
| ultraviolet curing agent | 3.5 g |
| 4-methoxyphenol | 0.5 g |

The corresponding wet weight composition, ready for coating, is as follows:

| | |
|---|---|
| high molecular weight polyurethane acrylate    (32% solution) | 333.3 g |
| epoxy acrylate | 15.0 g |
| polyisocyanurate (50% solution) | 19.6 g |
| ultraviolet curing agent | 3.5 g |
| 4-methoxyphenol | 0.5 g |

and toluene in the amount of 7 weight-% of the total.

As the laser energy source, a sealed $CO_2$ laser is used having a radio frequency-excited waveguide, a power output of 20 Watts CW (continuous wave), a Gaussian ($TEM_{oo}$) beam shape and a maximum modulation frequency of 10 KHz.

The laser energy is discharged toward the wire conductor in the form of a pulsed beam. The pulse width of the beam is about 200 microseconds. The spot is approximately circular and has a diameter of about 1 mm. The beam is pulsed when the conductor has been scribed about 0.2 mm. The scribing speed is about 5 m/min. The spot size and pulse frequency are adjusted so that each section of conductor receives about five laser pulses. The activated adhesive coating loses energy, becomes non-tacky and forms a bond with the surface within about 200 milliseconds.

When all conductors of the predetermined pattern have been scribed to the board, the adhesive coating is fully cured by exposure to ultraviolet light.

**Claims**

1. A process for scribing a conductor in a predetermined pattern on a surface of a substrate, the process comprising providing at least one conductor, a substrate the surface of which is to be scribed, and an adhesive for bonding said conductor to said surface; scribing the conductor on said surface of the substrate following a predetermined path, activating said adhesive along said predetermined path characterized in that the activating step is carried out by directing substantially uniform laser beam pulses at said adhesive; timing said pulses such that the pulse repetition rate is a function of the scribing speed.

2. The process of claim 1, characterized in that said timing is such that areas covered by successive pulses overlap.

3. The process of claim 2, characterized in that the areas overlap from 10 to 90% of the beam diameter.

4. The process of claim 1, characterized in that the adhesive is applied to the substrate surface prior to the scribing operation.

5. The process of claim 1, characterized in that the adhesive is applied as a coating on the conductor prior to the scribing operation.

6. The process of claim 1, characterized in that the adhesive is applied during the scribing operation.

7. The process of claim 1, wherein the conductor is an insulated conductor, characterized in that at least the ends of the insulated conductor are stripped of insulation by directing a laser beam of sufficient energy and proper wavelength thereto.

8. The process of claim 7, characterized in that said laser beam of sufficient energy and proper wavelength is a second laser beam.

9. The process of claim 1, characterized in that the substrate includes solder terminal points and at least one end of the conductor is stripped and soldered to said terminal point by directing a second laser beam thereto.

10. The process of claim 1 wherein the conductor is scribed between two terminal points on the substrate, characterized in that the conductor is cut after reaching the second terminal point by directing a laser beam of sufficient energy and proper wavelength thereto.

11. The process of claims 8 to 10, characterized in that the second laser beam provides pulsed laser energy with 100& overlap for at least part of the time.

12. The process of claim 11, characterized in that said laser beam employed for cutting has a different wavelength and energy level compared to the laser beam employed for activating the adhesive.

**Revendications**

1. Procédé pour tracer un conducteur suivant un motif prédéterminé sur la surface d'un substrat, ce procédé comprenant les étapes consistant à fournir au moins un conducteur, un substrat sur las surface duquel on doit procéder au traçage, et un adhésif pour lier le conducteur à la surface; à tracer le conducteur sur la surface du substrat en suivant un trajet prédéterminé, à activer l'adhésif suivant le trajet prédéterminé, caractérisé en ce que l'étape d'activation est exécutée en dirigeant des impulsions d'un faisceau laser sensiblement uniforme sur l'adhésif; en minutant les impulsions de facon que le taux de répétition des impulsions soit fonction de la vitesse de traçage.

2. Procédé selon la revendication 1, caractérisé en ce que le minutage tel que des zones couvertes par des impulsions successives se chevauchent.

3. Procédé selon la revendication 2, caractérisé en ce que les zones se chevauchent suivant 10 à 90 % du diamètre du faisceau.

4. Procédé selon la revendication 1, caractérisé en ce que l'adhésif est appliqué à la surface du substrat avant l'opération de traçage.

5. Procédé selon la revendication 1, caractérisé en ce que l'adhésif est appliqué à titre de revêtement au conducteur avant l'opération de traçage.

6. Procédé selon la revendication 1, caractérisé en ce que l'adhésif est appliqué pendant l'opération de

8

traçage.

7. Procédé selon la revendication 1, dans lequel le conducteur est un conducteur isolé, caractérisé en ce qu'au moins les extrémités du conducteur isolé sont séparées de l'isolant en dirigeant dessus un faisceau laser ayant une énergie suffisante et une longueur d'onde appropriée.

8. Procédé selon la revendication 7, caractérisé en ce que le faisceau laser ayant une énergie suffisante et une longueur d'onde appropriée est un second faisceau laser.

9. Procédé selon la revendication 1, caractérisé en ce que le substrat comprend des points de raccordement par soudure et en ce qu'au moins une extrémité du conducteur est dénudée et soudée au point de raccordement en dirigeant dessus un second faisceau laser.

10. Procédé selon la revendication 1, dans lequel le conducteur est tracé entre deux points de raccordement du substrat, caractérisé en ce que le conducteur est coupé après atteinte du second point de raccordement en dirigeant dessus un faisceau laser ayant une énergie suffisante et une longueur d'onde appropriée.

11. Procédé selon les revendications 8 à 10, caractérisé en ce que le second faisceau laser fournit une énergie laser pulsée avec un chevauchement de 100 % pour au moins une partie du temps.

12. Procédé selon la revendication 11, caractérisé en ce que le faisceau laser employé pour la coupe a une longueur d'onde et un niveau d'énergie différents par rapport au faisceau laser utilisé pour activer l'adhésif.

## Ansprüche

1. Ein Verfahren zum Aufbringen eines Leiterzuges entsprechend einem vorgegebenen Muster auf einer Oberfläche eines Trägers, wobei für das Verfahren mindestens ein Leiterzug, ein Träger, auf dessen Oberfläche der Leiterzug geschrieben wird, sowie ein Haftvermittler zum Verankern des Leiterzuges auf der Oberfläche erforderlich sind; Aufbringen des Leiterzuges in einem Schreibvorgang auf der Oberfläche entsprechend einem vorgebenen Weg, Aktivieren des Haftvermittlers entlang dem vorgegebenen Weg, **dadurch gekennzeichnet,** daß das Aktivieren vermittels auf den Haftvermittler gerichteter Laserstrahl-Impulse praktisch konstanter Energie durchgeführt wird, und daß die zeitliche Impulsfolge eine Funktion der jeweiligen Schreibgeschwindigkeit ist.

2. Das Verfahren nach Anspruch 1, dadurch gekennzeichnet, daß die zeitliche Impulsfolge so geregelt ist, daß die von den einzelnen Impulsen getroffenen Bezirke überlappen.

3. Das Verfahren nach Anspruch 2, dadurch gekennzeichnet, daß die überlappenden Bezirke 10 bis 90% des Strahldurchmessers entsprechen.

4. Das Verfahren nach Anspruch 1, dadurch gekennzeichnet, daß der Haftvermittler vor dem Schreibvorgang auf die Trägeroberflache aufgebracht wird.

5. Das Verfahren nach Anspruch 1, dadurch gekennzeichnet, daß der Haftvermittler als Leiterzugüberzug vor dem Schreibvorgang aufgebracht wird.

6. Das Verfahren nach Anspruch 1, dadurch gekennzeichnet, daß der Haftvermittler während des Schreibvorgangs aufgebracht wird.

7. Das Verfahren nach Anspruch 1, bei dem der Leiterzug ein isolierter Leiterzugdraht ist, dadurch gekennzeichnet, daß zumindest die Enden der isolierten Leiterzugdrähte durch einen auf diese gerichteten Laserstrahl ausreichender Energie und geeigneter Wellenlänge von der Drahtisolierung befreit werden.

8. Das Verfahren nach Anspruch 7, dadurch gekennzeichnet, daß der Laserstrahl ausreichender Energie und geeigneter Wellenlänge ein zweiter Laserstrahl ist.

9. Das Verfahren nach Anspruch 1, dadurch gekennzeichnet, daß der Träger mit Lötpunkten versehen ist, und daß der Leiterzugdraht mindestens an einem Ende von der Isolierung befreit und an dem Lötpunkt verlötet wird durch entsprechende Ausrichtung eines zweiten Laserstrahls.

10. Das Verfahren nach Anspruch 1, bei dem der Leiterzug mittels Drahtschreibung zwischen zwei Endpunkten auf der Oberfläche aufgebracht wird, dadurch gekennzeichnet, daß der Leiterzug nach dem Erreichen des zweiten Endpunktes durch einen auf diesen gerichteten Laserstrahl ausreichender Energie und geeigneter Wellenlänge abgetrennt wird.

11. Das Verfahren nach den Ansprüchen 8 bis 10, dadurch gekennzeichnet, daß der zweite Laserstrahl eine pulsierende Laserstrahlenergie abgibt mit 100% Überlappung für mindestens einen Teil der Impulsdauer.

12. Das Verfahren nach Anspruch 11, dadurch gekennzeichnet, daß der zum Abtrennen verwendete Laserstrahl eine andere Wellenlänge und eine andere Leistung aufweist als jener zum Aktivieren des Haftvermittlers.

Fig. 1

Fig. 2

Fig. 3 A

Fig. 3 B

Fig. 3 C